(19) Europäisches Patentamt

European Patent Office

Office européen des brevets

(11) **EP 0 897 614 B1**

(12) **EUROPÄISCHE PATENTSCHRIFT**

(45) Veröffentlichungstag und Bekanntmachung des Hinweises auf die Patenterteilung:
**08.11.2000   Patentblatt 2000/45**

(21) Anmeldenummer: **97921617.3**

(22) Anmeldetag: **17.04.1997**

(51) Int Cl.⁷: **H03K 5/151**, H03K 5/04

(86) Internationale Anmeldenummer:
**PCT/DE97/00775**

(87) Internationale Veröffentlichungsnummer:
**WO 97/42707 (13.11.1997 Gazette 1997/49)**

(54) **TAKTSIGNALGENERATOR**

CLOCK SIGNAL GENERATOR

GENERATEUR DE SIGNAL D'HORLOGE

(84) Benannte Vertragsstaaten:
**DE FR GB**

(30) Priorität: **06.05.1996  DE 19618096**

(43) Veröffentlichungstag der Anmeldung:
**24.02.1999   Patentblatt 1999/08**

(73) Patentinhaber: **SIEMENS AKTIENGESELLSCHAFT**
**80333 München (DE)**

(72) Erfinder:
• **GREHL, Udo**
**D-81543 München (DE)**
• **DALLMANN, Achim**
**D-85598 Baldham (DE)**

(56) Entgegenhaltungen:
**EP-A- 0 183 875**     **EP-A- 0 431 761**
**EP-A- 0 579 855**     **EP-A- 0 606 912**
**US-A- 4 675 546**     **US-A- 4 939 677**
**US-A- 5 086 236**

• **PATENT ABSTRACTS OF JAPAN vol. 014, no. 354 (E-0958), 31.Juli 1990 & JP 02 124627 A (NEC CORP), 11.Mai 1990,**
• **PATENT ABSTRACTS OF JAPAN vol. 013, no. 285 (E-780), 29.Juni 1989 & JP 01 068016 A (HITACHI LTD;OTHERS: 01), 14.März 1989,**
• **PATENT ABSTRACTS OF JAPAN vol. 015, no. 476 (E-1140), 4.Dezember 1991 & JP 03 204222 A (NEC CORP), 5.September 1991,**

**Beschreibung**

Die vorliegende Erfindung betrifft einen Taktsignalgenerator, wobei das Tastverhältnis der erzeugten Taktsignale programmierbar ist.

Eine getaktete Logikschaltung ist beispielsweise aus der EP-A 0183 875 bekannt geworden. Diese eignet sich jedoch nicht zur Erzeugung von Taktsignalen der genannten Art.

Taktsignalgeneratoren der genannten Art werden unter anderem beispielsweise zur Steuerung von Master/Slave-Registern und dergleichen verwendet. Master/Slave-Register enthalten zwei hintereinander geschaltete Speicherelemente, nämlich einen sogenannten Master-Speicher und einen sogenannten Slave-Speicher, welche unter Verwendung von zwei voneinander verschiedenen Taktsignalen gesteuert werden. Genauer gesagt wird durch das erste Taktsignal der Zeitpunkt der Übernahme von anliegenden Daten in den Master-Speicher, und durch das zweite Taktsignal der Zeitpunkt der Übernahme von im Master-Speicher gespeicherten Daten in den Slave-Speicher bestimmt.

Die Übernahme von Daten aus dem Master-Speicher in den Slave-Speicher darf in der Regel erst dann erfolgen, wenn das den Master-Speicher steuernde Taktsignal einen Zustand angenommen hat, das ein Einspeichern von Daten in den Master-Speicher unterbindet; anderenfalls könnten sich die im Master-Speicher gespeicherten Daten während der Übernahme in den Slave-Speicher noch ändern, was normalerweise tunlichst zu verhindern ist.

Das erste Taktsignal und das zweite Taktsignal dürfen sich demzufolge nie gleichzeitig in einem Zustand befinden, der eine Übernahme von Daten in die jeweiligen Speicher erlaubt.

Dies kann beispielsweise dadurch erreicht werden, daß das zweite Taktsignal durch eine Invertierung des ersten Taktsignals generiert wird, die Taktsignale also einen im wesentlichen komplementären Verlauf aufweisen. Derart generierte Taktsignale sind grundsätzlich für die Steuerung von Master/ Slave-Systemen und dergleichen geeignet.

Allerdings kann aufgrund von Signal-Laufzeiten, Bauelemente-Toleranzen etc. der Fall auftreten, daß es bei den Taktsignalen unerwünschter Weise gleichwohl zu den vorstehend genannten, zu vermeidenden Überlappungen in den Signalverläufen kommt, was insbesondere bei hohen Taktfrequenzen und dementsprechend schnell ansprechenden Speichern ein ernsthaftes Problem darstellt.

Zur Vermeidung dessen kann vorgesehen werden, die zueinander inversen Taktsignale derart zu bearbeiten, daß zwischen der jeweiligen Aktiv-Phase des einen Taktsignals und der darauf folgenden Aktiv-Phase des anderen Taktsignals eine sogenannte Nichtüberlappungs-Phase erzwungen wird, während welcher sich beide Taktsignale in einer Inaktiv-Phase, beispielsweise in einer Niedrigpegel-Phase befinden.

Das Vorsehen einer solchen Nichtüberlappungs-Phase kann (unter Beibehaltung der jeweiligen Taktfrequenzen) durch eine entsprechende Verschiebung der steigenden und/oder fallenden Flanken des ersten und/oder des zweiten Taktsignals erfolgen, was unter Verwendung von entsprechenden Verzögerungsstufen bewerkstelligbar ist. Aus der EP 0 606 912 A2 ist ein Taktgenerator mit zwei Verzögerungsschaltkreisen und mit Verzögerungssteuerregistern bekannt zur Erzeugung zweier nicht überlappender Taktsignale.

Die EP 0 431 761 A2 offenbart einen CMOS-Taktgenerator zur Erzeugung von Phasentaktsignalen mit einstellbarer Überlappung.

Die US 4,675,546 beschreibt einen programmierbaren Signalgenerator mit stufenweise einstellbaren Pulsweiten.

Wenngleich die Verwendung derartiger, an die vermeintlichen Verhältnisse angepaßter Taktsignale in der Regel eine erheblich zuverlässigere Ansteuerung von Master/Slave-Registern und dergleichen ermöglicht, treten in der Praxis dennoch immer wieder Fälle auf, in denen Master/Slave-Register oder dergleichen trotz des Vorsehens der genannten Maßnahmen nicht ordnungsgemäß betreibbar sind, was eine häufig sehr umfangreiche und dementsprechend aufwendige Ursachenforschung und Umgestaltung, der betroffenen Schaltung oder der davon betroffenen Schaltungsteile erfordert.

Entsprechendes gilt auch für den Fall, daß das Tastverhältnis der verwendeten Taktsignale für den nicht ordnungsgemäßen Betrieb der Master/Slave-Register oder dergleichen verantwortlich ist; auch hier führt eine Anpassung an die vermeintlichen Verhältnisse nicht automatisch zu einem ordnungsgemäßen Betrieb der Master/Slave-Register.

Der vorliegenden Erfindung liegt daher das Problem zugrunde einen Taktsignalgenerator vorzuschlagen, bei dem durch die Taktsignale des Taktsignalgenerators gesteuerte Master/Slave-Register oder dergleichen auf einfache Weise stets ordnungsgemäß betreibbar sind.

Dieses Problem wird erfindungsgemäß durch einen Taktsignalgenerator mit den Merkmalen von Patentanspruch 1 gelöst. Vorteilhafte Ausgestaltungen dieses Taktsignalgenerators sind in den abhängigen Ansprüchen angegeben.

Vorteilhafterweise ist vorgesehen, daß eine Verzögerungsstufe mehrere parallel verschaltete, unterschiedlich lang verzögernde Verzögerungsglieder und eine Auswahleinrichtung aufweist, über welche bestimmbar ist, welches der Ausgangssignale der Verzögerungsglieder als Ausgangssignal der Verzögerungsstufe ausgegeben werden soll.

Auf diese Weise ist es möglich, die Länge der Aktiv-Phasen und der Inaktiv-Phasen der jeweiligen Taktsignale und die Länge der Nichtüberlappungs-Phasen auch noch nach der Fertigstellung des Taktgenerators und der durch diesen anzusteuernden Schaltung individuell an die jeweiligen tatsächlichen Gegebenheiten anzupassen, wodurch ein jeweils optimaler Betrieb der durch den erfindungsgemäßen Taktsignalgenerator anzusteuernden Vorrichtung erzielbar ist.

Verwendet man den erfindungsgemäßen Taktsignalgenerator als einen in einer integrierten Schaltung vorzusehenden Taktsignalgenerator zur Ansteuerung der ebenfalls in der integrierten Schaltung vorgesehenen Master/Slave-Register oder dergleichen, so lassen sich Fehlfunktionen der integrierten Schaltung, die auf einer nicht ordnungsgemäßen Ansteuerung der Master/Slave-Register beruhen und deren Behebung bislang nicht selten einen kompletten Neuentwurf (Redesign) der integrierten Schaltung erforderten, häufig einfach durch ein entsprechend modifiziertes Betreiben des Taktsignalgenerators, genauer gesagt dessen Verzögerungsstufe(n) bzw. deren Auswahleinrichtung(en) beseitigen.

Es wurde mithin ein Taktsignalgenerator geschaffen, durch welchen durch die Taktsignale des Taktsignalgenerators gesteuerte Master/Slave-Register oder dergleichen auf einfache Weise stets ordnungsgemäß betreibbar sind.

Weitere Vorteile, Merkmale und Anwendungsmöglichkeiten der Erfindung ergeben sich aus den im folgenden beschriebenen Ausführungsbeispielen in Verbindung mit der Zeichnung. Es zeigen

Figur 1 ein den prinzipiellen Aufbau eines Ausführungsbeipiels des erfindungsgemäßen Taktsignalgenerators zeigendes Blockschaltbild,

Figur 2 ein Blockschaltbild zur Erläuterung einer möglichen Realisierung eines in der Figur 1 gezeigten ersten Blocks 100, und

Figur 3 ein Blockschaltbild zur Erläuterung einer möglichen Realisierung eines in der Figur 1 gezeigten zweiten Blocks 200.

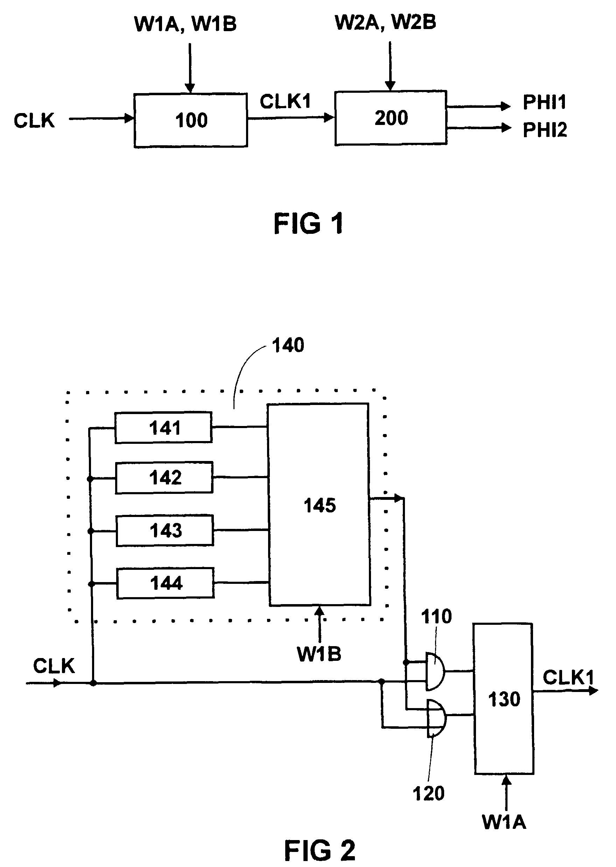

Gemäß der Darstellung in der Figur 1 besteht der erfindungsgemäße Taktsignalgenerator aus zwei Blöcken, nämlich einem ersten Block 100 und einem zweiten Block 200.

Aufgabe des betrachteten Taktsignalgenerators ist es, aus einem Eingabe-Taktsignal CLK ein erstes Ausgabe-Taktsignal PHI1 und ein zweites Ausgabe-Taktsignal PHI2 zu generieren, um ein Master/Slave-Register oder dergleichen ordnungsgemäß ansteuern zu können.

Der Einsatz des erfindungsgemäßen Taktsignalgenerators ist jedoch nicht auf die beschriebene Verwendung zur Ansteuerung von Master/Slave-Registern und dergleichen beschränkt; die Erfindung ist vielmehr überall dort anwendbar, wo es gilt, ein oder mehrere Taktsignale unter jeweils optimaler Anpassung an deren Verwendungszweck zu generieren bzw. bereitzustellen.

Der erste Block 100 erhält das Eingangs-Taktsignal CLK als Eingangssignal und gibt ein Ausgangssignal (Zwischen-Taktsignal) CLK1 aus, welches - sofern erforderlich - gegenüber dem Eingangs-Taktsignal CLK hinsichtlich des Tastverhältnisses verändert ist. Ob und inwieweit das ursprüngliche Tastverhältnis modifiziert wird, wird durch von außen in den ersten Block 100 eingegebene Steuersignale W1A und W1B bestimmt. Der innere Aufbau des ersten Blocks 100 sowie die Wirkung der Steuersignale werden später unter Bezugnahme auf die Figur 2 detailliert beschrieben.

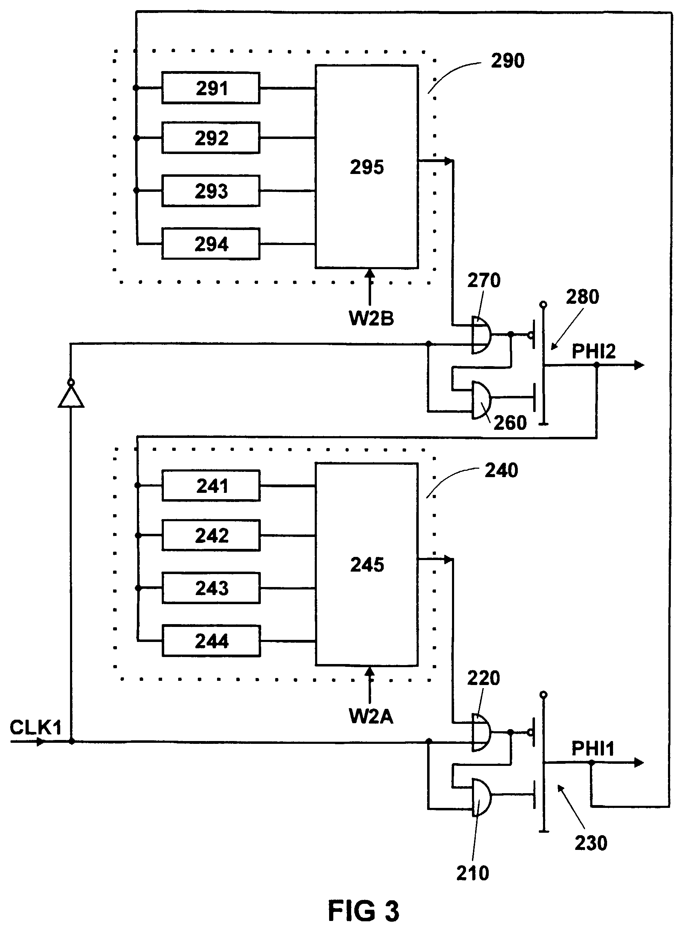

Der zweite Block 200 erhält das Ausgangssignal (Zwischen-Taktsignal) CLK1 des ersten Blockes 100 als Eingangssignal und gibt das erste (PHI1) Ausgangs-Taktsignal und das zweite (PHI2) Ausgangs-Taktsignal als Ausgangssignale aus, wobei diese Signale zunächst einen im wesentlichen komplementären Amplitudenverlauf aufweisen und - sofern erforderlich - darüber hinaus hinsichtlich der Dauer der eingangs bereits erwähnten Nichtüberlappungs-Phase modifiziert sind. Ob und inwieweit eine ursprünglich nicht vorhandene Nichtüberlappungs-Phase (bei genau komplementär verlaufenden Signalen ist die Nichtüberlappungs-Phase jeweils gleich null) generiert wird, wird durch von außen in den zweiten Block 200 eingegebene Steuersignale W2A und W2B bestimmt. Der innere Aufbau des zweiten Blocks 200 sowie die Wirkung der Steuersignale werden später unter Bezugnahme auf die Figur 3 detailliert beschrieben.

Es wird nun zunächst unter Bezugnahme auf die Figur 2 der erste Block 100 näher beschrieben.

Der erste Block 100 besteht aus einem UND-Glied 110, einem ODER-Glied 120, einem ersten Multiplexer 130 und einer Verzögerungsstufe 140, die wie in der Figur 2 gezeigt verschaltet sind.

Das Kernstück der in der Figur 2 gezeigten Schaltung ist die Verzögerungsstufe 140.

Würde diese Verzögerungsstufe 140 durch ein durchgehendes Leitungselement ersetzt werden, wären das in den ersten Block 100 eingegebene Eingangssignal CLK und das aus dem ersten Block ausgegebene Ausgangssignal CLK1 vollkommen identisch, und zwar unabhängig davon, ob durch den über das Signal W1A ansteuerbaren Multiplexer 130 das Ausgangssignal des UND-Gliedes 110 oder das Ausgangssignal des ODER-Gliedes 120 als Ausgangssignal CLK1 ausgegeben wird. In diesem Fall wären nämlich sowohl die in das UND-Glied 110 eingegebenen Signale als auch die in das ODER-Glied 120 eingegebenen Signale zu jedem beliebigen Zeitpunkt exakt identisch, nämlich gleich dem in den ersten Block 100 eingegebene Eingangssignal CLK.

Im Unterschied hierzu können das UND-Glied 110 und das ODER-Glied 120 infolge des Vorsehens der Verzögerungsstufe 140 jeweils eines ihrer Eingangssignale zeitlich versetzt erhalten, woraus erkennbar eine zeitliche Verschiebung der steigenden oder der fallenden Flanken im Ausgangssignal CLK1 resultiert. Genauer gesagt sind bei Verwendung des Ausgangssignals des UND-Gliedes 110 als Ausgangssignal CLK1 aus dem Multiplexer 130 (und aus dem ersten Block 100) dessen Flanken derart verschoben, daß das Signal später auf den hohen Pegel ansteigt oder früher auf den niedrigen Pegel abfällt als dies beim Eingangssignal CLK der Fall ist, woraus sich eine Verkürzung der Hochpegel-Phase (Verlängerung der Niedrigpegel-Phase), also eine Veränderung des Tastverhältnisses ergibt; andererseits sind bei Verwendung des Ausgangssignals des ODER-Gliedes 120 als Ausgangssignal CLK1 aus dem Multiplexer 130 (und aus dem ersten Block 100) dessen Flanken derart verschoben, daß das Signal früher auf den hohen Pegel ansteigt oder später auf den niedrigen Pegel abfällt als dies beim Eingangssignal CLK der Fall ist, woraus sich eine Verlängerung der Hochpegel-Phase (Verkürzung der Niedrigpegel-Phase), also ebenfalls eine Veränderung des Tastverhältnisses ergibt.

Der Umfang der Veränderung des Tastverhältnisses wird durch den Umfang der Verzögerung durch die Verzögerungsstufe 140 bestimmt. Diese ist nun erfindungsgemäß derart aufgebaut, daß sie eine Vielzahl von parallel verschalteten Verzögerungsgliedern 141 bis 144 und eine Auswahleinrichtung in Form eines zweiten Multiplexers 145 aufweist. Die mehreren Verzögerungsglieder 141 bis 144 sind derart ausgebildet, daß durch diese beliebig festlegbare, aber voneinander verschiedene Verzögerungen der jeweils eingegebenen Signale realisierbar sind, wobei auch eine Verzögerung gleich null, also keine Verzögerung erlaubt sein möge. Sämtliche Verzögerungsglieder werden mit ein und demselben Eingangssignal, nämlich dem Eingangs-Taktsignal CLK beaufschlagt. Dieses Signal wird entsprechend der jeweiligen Verzögerung durch das jeweilige Verzögerungsglied verzögert, aber ansonsten unverändert als jeweiliges Ausgangssignal aus dem jeweiligen Verzögerungsglied ausgegeben. Die Ausgangssignale aller Verzögerungsglieder 141 bis 144 werden in den Multiplexer 145 eingegeben.

Durch den Multiplexer 145 ist in Abhängigkeit von dem von außen zugeführten Steuersignal W1B auswählbar bzw. festlegbar, welches der in den Multiplexer 145 eingegebenen Signale als Ausgangssignal aus diesem (und zugleich aus der Verzögerungsstufe 140) ausgegeben werden soll.

Die von außen in den ersten Block 100 bzw. in dessen Multiplexer 130 und 145 eingeführten Steuersignale W1A und W1B ermöglichen also die Einstellung bzw. die gezielte Veränderung des Tastverhältnisses des Eingangs-Taktsignals CLK, und zwar sowohl hinsichtlich der Art (Steuersignal W1A) als auch hinsichtlich und des Umfanges (Steuersignal W1B).

Die Steuersignale W1A und W1B, genauer gesagt deren zeitliche Verläufe und/oder Werte können in einer Speichereinheit wie einem Register oder dergleichen gespeichert sein oder durch eine entsprechende Verdrahtung oder dergleichen fest eingestellt sein.

Die Speicherung in einem Register oder dergleichen hat den Vorteil, daß die entsprechenden Werte dann jederzeit, also auch während des Betriebes (dynamisch) veränderbar sind. Dies ermöglicht eine besonders flexible Anpassung an die jeweiligen Gegebenheiten, was insbesondere bei einer gegebenenfalls erforderlichen Berücksichtigung zeitlich veränderlicher Bedingungen wie Temperatur, Alterung etc. von nicht unerheblicher Bedeutung ist und darüber hinaus unter anderem auch eine automatische Taktsignal-Einstellung im Rahmen eines Selbsttests der Schaltung nach deren Einschalten oder dergleichen erlaubt. Die zur Einspeicherung entsprechender Anfangswerte oder aktualisierter Werte in das Register oder dergleichen sowie die zu deren Verwendung als Steuersignale W1A und W1B vorzusehenden Maßnahmen dürften bekannt sein und bedürfen keiner weiteren Erläuterung.

Die nachträglich nicht mehr veränderbare Festlegung der Steuersignale beispielsweise durch eine entsprechende Verdrahtung beseitigt mögliche Fehlerquellen (durch falsche Programmierung der Taktsignal-Einstellung), schützt vor Manipulationen und vereinfacht unter Umständen die Ansteuerung des Taktgenerators. Eine der Möglichkeiten zur praktischen Durchführung einer derartigen Steuersignal-Festlegung besteht in einem Zerstören von nicht gewünschten Einstellungen der Taktsignale entsprechenden Verdrahtungen, die ursprünglich, d.h. nach der Herstellung der betreffenden Schaltung bzw. des betreffenden Schaltungsteils noch unversehrt vorhanden sind. Die entsprechenden Verbindungen können beispielsweise mit Hilfe eines Laserstrahls aufgetrennt werden und sollten in diesem Fall an einer gut zugänglichen Stelle liegen. Eine andere Möglichkeit zur praktischen Durchführung der danach nicht mehr veränderbaren Steuersignal-Festlegung besteht darin, daß die den nicht gewünschten Einstellungen der Taktsignale entsprechenden Verbindungen bereits bei der Herstellung weggelassen werden; sich nachträglich als erforderlich erweisende Änderungen sind dann, sofern die mögliche Notwendigkeit derartiger Modifikationen beim Schaltungsentwurf gebührend berücksichtigt wurde, unter minimalem Aufwand (Ersetzen einer Verbindung durch eine andere) realisierbar. Eine weitere Möglichkeit zur praktischen Durchführung einer nicht mehr veränderbaren Steuersignal-Festlegung besteht darin, daß als Speichereinrichtung zum Speichern der zeitliche Verläufe und/oder Werte der Steuersignale ein (bei Bedarf löschbarer) Festspeicher (ROM, PROM, EPROM, EEPROM, Flash-EPROM) verwendet wird.

Allen Möglichkeiten zur veränderbaren oder nicht mehr veränderbaren Festlegung der Steuersignale W1A und W1B ist gemeinsam, daß diese auch noch nach der Fertigstellung des Taktgenerators und/oder der durch diesen anzusteuernden Schaltung auf einfache Weise, d.h. zumindest ohne umfangreiche Umgestaltung des Taktgenerators und/oder der Schaltung jeweils optimal, und nicht nur ungefähr) an die tatsächlichen Verhältnisse anpaßbar sind. Dies ist, wie eingangs bereits erwähnt wurde, bei in integrierten Schaltungen integrierten Taktsignalgeneratoren von besonderem Vorteil.

Im vorliegenden Ausführungsbeispiel ist durch die Steuersignale W1A und W1B die Veränderung des Tastverhältnisses des Eingangs-Taktsignals CLK sowohl hinsichtlich der Art (Steuersignal W1A) als auch hinsichtlich und des Umfanges (Steuersignal W1B) beeinflußbar.

Die mit Hilfe der Steuersignale W1A und W1B vornehmbare Beeinflussung des Tastverhältnisses ermöglicht allein oder im Zusammenwirken mit der noch zu erläuternden Einstellbarkeit der Dauer der Nichtüberlappungs-Phase eine äußerst genaue individuelle Anpassung an die jeweiligen Gegebenheiten.

Es wird nun unter Bezugnahme auf die Figur 3 der zweite Block 200 näher beschrieben.

Der zweite Block 200 läßt sich in zwei weitgehend identisch aufgebaute Teilblöcke untergliedern, nämlich einen ersten Teilblock zur Generierung des ersten Ausgangs-Taktsignals PHI1 und einen zweiten Teilblock zur Generierung des zweiten Ausgangs-Taktsignals PHI2.

Der erste Teilblock besteht aus einem UND-Glied 210, einem ODER-Glied 220, einem durch das UND-Glied und das ODER-Glied angesteuerten Transistorpaar 230 (hier ein Paar von Feldeffekttransistoren), und einer Verzögerungsstufe 240, die wie in der Figur 3 gezeigt verschaltet sind.

Das Kernstück des ersten Teilblocks der in der Figur 3 gezeigten Schaltung ist die Verzögerungsstufe 240.

Würde diese Verzögerungsstufe 240 durch ein durchgehendes Leitungselement ersetzt werden, dann würde das aus dem ersten Teilblock des zweiten Blocks 200 ausgegebene Ausgangssignal PHI1 genau dem invertierten Eingangssignal (Zwischen-Taktsignal) CLK1 entsprechen. Der dem UND-Glied 210 zugeordnete Transistor schaltet nämlich bei einem Hochpegel-Ausgang ("1") des UND-Gliedes einen Niedrigpegel durch, und der dem ODER-Glied 220 zugeordnete Transistor schaltet bei einem Niedrigpegel-Ausgang ("0") des ODER-Gliedes 220 einen Hochpegel durch.

Im Unterschied hierzu kann das ODER-Glied 220 infolge des Vorsehens der Verzögerungsstufe 240 das von dieser erhaltene Eingangssignal derart zeitlich versetzt erhalten, daß die Hochpegel-Phase des Ausgangssignals des ODER-Gliedes zeitlich verlängert wird (verkürzt kann diese Phase nicht werden, weil das zweite Eingangssignal des ODER-Gliedes 220 das in den zweiten Block 200 eingegebene Eingangssignal CLK1 selbst und die Mindestdauer der Hochpegel-Phase des Ausgangssignals des ODER-Gliedes damit unveränderbar, genauer gesagt durch die Verzögerungsstufe 240 unveränderbar festgelegt ist), so daß das Durchschalten des dem ODER-Glied zugeordneten Transistors und mithin auch das Durchschalten der Hochpegelspannung auf den Ausgang PHI1 erkennbar zeitlich verkürzt ist. Im Endeffekt bewirkt das Vorsehen der Verzögerungsstufe 240 im ersten Teilblock des zweiten Blockes 200 also eine Beeinflussung des ersten Ausgangs-Taktsignals PHI1 dahingehend, daß dieses - verglichen mit dem Fall, daß keine Signalverzögerung vorgesehen ist - später auf den hohen Pegel ansteigt oder früher auf den niedrigen Pegel abfällt als dies beim Eingangssignal CLK1 der Fall ist.

Der zweite Teilblock des zweiten Blockes 200 ist hinsichtlich des Aufbaus mit dem ersten Teilblock identisch. D.h., der zweite Teilblock weist ein dem UND-Glied 210 entsprechendes UND-Glied 260, ein dem ODER-Glied 220 entsprechendes ODER-Glied 270, ein dem Transistorpaar 230 entsprechendes Transistorpaar 280, und eine der Verzögerungsstufe 240 entsprechende Verzögerungsstufe 290 auf, die wie in der Figur 3 gezeigt verschaltet sind.

Im Unterschied zum ersten Teilblock ist das in den zweiten Teilblock eingegebene Signal die mittels eines Inverters invertierte Fassung des in den ersten Teilblock eingegebenen Signals CLK1, d.h. $\overline{CLK1}$. Ferner sind die durch die Verzögerungsstufen 240 bzw. 290 zu verzögernden Signale verschieden (PHI2 im Fall der Verzögerungsstufe 240 des ersten Teilblocks; PHI1 im Fall der Verzögerungsstufe 290 des zweiten Teilblocks).

Die genannten Unterschiede ändern jedoch nichts an der prinzipiellen Übereinstimmung von Funktion und Wirkungsweise von erstem und zweitem Teilblock.

Das Kernstück des zweiten Teilblocks der in der Figur 3 gezeigten Schaltung ist wie beim ersten Teilblock auch hier die Verzögerungsstufe 290.

Würde diese Verzögerungsstufe 290 durch ein durchgehendes Leitungselement ersetzt werden, dann würde das aus dem zweiten Teilblock des zweiten Blocks 200 ausgegebene Ausgangssignal PHI2 genau dem Inversen des Eingangssignals $\overline{CLK1}$, also genau CLK1 entsprechen. Der dem UND-Glied 260 zugeordnete Transistor schaltet nämlich bei einem Hochpegel-Ausgang ("1") des UND-Gliedes einen Niedrigpegel durch, und der dem ODER-Glied 270 zugeordnete Transistor schaltet bei einem Niedrigpegel-Ausgang ("0") des ODER-Gliedes einen Hochpegel durch.

Im Unterschied hierzu kann das ODER-Glied 270 infolge des Vorsehens der Verzögerungsstufe 290 das von dieser erhaltene Eingangssignal derart zeitlich versetzt erhalten, daß die Hochpegel-Phase des Ausgangssignals des ODER-Gliedes zeitlich verlängert wird (verkürzt kann diese Phase nicht werden, weil das zweite Eingangssignal des ODER-Gliedes 270 das in den zweiten Teilblock eingegebene Signal $\overline{CLK1}$ selbst und die Mindestdauer der Hochpegel-Phase des Ausgangssignals des ODER-Gliedes damit unveränderbar, genauer gesagt durch die Verzögerungsstufe 290 unveränderbar festgelegt ist), so daß das Durchschalten des dem ODER-Glied 270 zugeordneten Transistors und mithin auch das Durchschalten der Hochpegelspannung auf den Ausgang PHI2 erkennbar zeitlich verkürzt ist. Im Endeffekt bewirkt das Vorsehen der Verzögerungsstufe 290 im zweiten Teilblock des zweiten Blockes 200 also eine Beeinflussung des zweiten Ausgangs-Taktsignals PHI2 dahingehend, daß dieses - verglichen mit dem Fall, daß keine Signalverzögerung vorgesehen ist - später auf den hohen Pegel ansteigt oder früher auf den niedrigen Pegel abfällt als dies beim Eingangssignal $\overline{CLK1}$ der Fall ist.

Die Verkürzung der Hochpegel-Phasen (Verlängerung der Niedrigpegel-Phasen) der von Haus aus, d.h. ohne Verzögerungsstufen inversen bzw. komplementär verlaufenden Ausgangs-Taktsignale PHI1 und/oder PHI2 bewirkt automatisch das Vorsehen einer zunächst nicht vorhandenen, sogenannten Nichtüberlappungs-Phase, in welcher sich sowohl das Ausgangs-Taktsignal PHI1 als auch das Ausgangs-Taktsignal PHI2 in einer Niedrigpegel-Phase befinden.

Die Schaltung ist vorzugsweise derart aufgebaut, daß eine an den Ausgängen PHI1/PHI2 anliegende Kapazität automatisch die Nichtüberlappungszeit erhöht und die Nichtüberlappungszeiten der Verzögerungsstufen 240/290 additiv dazugeschaltet werden können.

Der Umfang der Verkürzung der Hochpegel-Phasen (Verlängerung der Niedrigpegel-Phasen) der Ausgangs-Taktsignale PHI1 und/oder PHI2 bzw. die Dauer der sich dadurch einstellenden Nichtüberlappungs-Phase wird durch den Umfang der Verzögerung (en) durch die Verzögerungsstufen 240 und/oder 290 bestimmt. Diese Verzögerungsstufen sind nun erfindungsgemäß derart aufgebaut, daß sie jeweils eine Vielzahl von parallel verschalteten Verzögerungsgliedern 241 bis 244 bzw. 291 bis 294 und eine Auswahleinrichtung in Form eines Multiplexers 245 bzw. 295 aufweisen. Die mehreren Verzögerungsglieder 241 bis 244 bzw. 291 bis 294 sind derart ausgebildet, daß durch diese beliebig festlegbare, aber voneinander verschiedene Verzögerungen der jeweils eingegebenen Signale realisierbar sind, wobei jeweils auch eine Verzögerung gleich null, also keine Verzögerung erlaubt sein möge. Sämtliche Verzögerungsglieder einer jeweiligen Verzögerungsstufe werden mit ein und demselben Eingangssignal, nämlich dem Signal PHI2 (Verzögerungsglieder der Verzögerungsstufe 240) bzw. PHI1 (Verzögerungsglieder der Verzögerungsstufe 290) beaufschlagt. Die jeweils eingegebenen Signale werden entsprechend der jeweiligen Verzögerung durch das jeweilige Verzögerungsglied verzögert, aber ansonsten unverändert als jeweiliges Ausgangssignal ausgegeben. Die Ausgangssignale aller Verzögerungsglieder 241 bis 244 bzw. 291 bis 294 werden in die jeweiligen Multiplexer 245 bzw. 295 eingegeben. Durch die Multiplexer 245 bzw. 295 ist in Abhängigkeit von den diesen von außen zugeführten Steuersignalen W2A bzw. W2B auswählbar bzw. festlegbar, welches der in die jeweiligen Multiplexer 245 bzw. 295 eingegebenen Signale als Ausgangssignal aus diesen ausgegeben werden soll.

Die von außen in den zweiten Block 200 bzw. in dessen Multiplexer 245 bzw. 295 eingeführten Steuersignale W2A und W2B ermöglichen also die Einstellung bzw. die gezielte Veränderung der Dauer der Nichtüberlappungs-Phase der Ausgangs-Taktsignale PHI1 und PHI2. Sie lassen dadurch allein oder im Zusammenwirken mit der im ersten Block 100 durchgeführten Tastverhältnis-Einstellung selektiv und individuell eine jeweils optimale Anpassung der Ausgangs-Taktsignale PHI1 und PHI2 an die jeweiligen Gegebenheiten zu.

Hinsichtlich der Speicherung oder der sonstigen Festlegung der Steuersignale W2A und W2B, genauer gesagt deren zeitliche Verläufe und/oder Werte wird auf die entsprechenden Ausführungen zu den Steuersignalen W1A und W1B verwiesen.

Die Anzahl der pro Verzögerungsstufe vorzusehenden verzögerungsglieder ist sowohl im ersten Block als auch im zweiten Block unabhängig voneinander beliebig festlegbar. Auch der durch die jeweiligen Verzögerungsglieder bewirkte Umfang der Verzögerung ist individuell festlegbar; insbesondere ist es, wie vorstehend bereits erwähnt, auch möglich, jeweils ein 'Verzögerungsglied" mit der Verzögerung null vorzusehen.

Selbstverständlich ist es auch möglich, einzelne Komponenten des beschriebenen Taktgenerators wegzulassen. Gegenstand der Weglassung kann ausgewählte einzelne oder mehrere Multiplexer einschließlich dann überflüssiger Signalzweige gemäß der Figur 3 sein.

Im beschriebenen Ausführungsbeispiel wurde davon ausgegangen, daß die steigenden Flanken oder die Hochpegel-Phasen der jeweiligen Ausgangs-Taktsignale die Ereignisse oder Phasen sind, die in den durch diese Signale anzusteuernden Vorrichtungen ein Ereignis auslösen. Selbstverständlich können statt dessen auch die fallenden Flanken oder die Niedrigpegel-Phasen der jeweiligen Ausgangs-Taktsignale die Ereignisse oder Phasen sein, die in den durch diese Signale anzusteuernden Vorrichtungen ein Ereignis auslösen; die beschriebene Schaltung bedarf dann insbesondere hinsichtlich der Einstellung der Nichtüberlappungs-Phase im zweiten Block 200 einer entsprechenden Modifizierung, zu welcher der Fachmann jedoch auch ohne detaillierte Erläuterung in der Lage sein dürfte.

**Patentansprüche**

1. Taktsignalgenerator mit programmierbarem Tastverhältnis mit einem Takteingang für ein Taktsignal (CLK), einem ersten und einem zweiten Taktausgang, mindestens einer ersten Verzögerungsstufe (140) mit wählbarer Verzögerung zur Verzögerung des Taktsignals und einer steuerbaren Logikschaltung (110, 120, 130), wobei aus dem Taktsignal (CLK) und mindestens einem gewählten, verzögerten Signal ein erstes (PHI1) und ein zweites (PHI2) Taktausgangssignal gebildet wird,
wobei die Logikschaltung ein UND-Gatter (110) und ein ODER-Gatter (120) mit jeweils zwei Eingängen aufweist, an die jeweils das unverzögerte Taktsignal und das in der ersten Verzögerungsstufe (140) verzögerte Signal angelegt ist und wobei wählbar die Ausgabe des UND-Gatters (110) oder des ODER-Gatters (120) einer ersten (210, 220, 230) und einer zweiten (260, 270, 280) Logikanordnung zugeführt wird.

2.  Taktsignalgenerator nach Anspruch 1,
    **dadurch gekennzeichnet,**
    daß die Auswahl des verzögerten Signals mittels Multiplexer (145) erfolgt, der mit einer Vielzahl von Verzögerungsstrecken (141-144) verbunden ist und der durch ein von außen eingebbares Steuersignal (W1B) steuerbar ist.

3.  Taktsignalgenerator nach Anspruch 1,
    **dadurch gekennzeichnet,**
    daß die Auswahl eines verzögerten Signals durch Modifikationen an der Verdrahtung eines Schaltungsentwurfs erfolgt, der eine Vielzahl von Verzögerungsstrecken (141-144) aufweist.

4.  Taktsignalgenerator nach Anspruch 1,
    **dadurch gekennzeichnet,**
    daß die Auswahl eines verzögerten Signals durch nachträgliches Trennen von Verdrahtungen einer Schaltung erfolgt, die eine Vielzahl von Verzögerungsstrecken (141-144) aufweist.

5.  Taktsignalgenerator nach Anspruch 4,
    **dadurch gekennzeichnet,**
    daß das Trennen von Verbindungen mittels Laserstrahl erfolgt.

6.  Taktsignalgenerator nach Anspruch 1,
    **dadurch gekennzeichnet,**
    daß die erste Logikanordnung ein erstes Taktausgangssignal (PHI1) bildet und die zweite Logikanordnung ein zweites Taktausgangssignal (PHI2) bildet und wobei das zweite Taktausgangssignal (PHI2) über eine zweite Verzögerungsstufe (240) der ersten Logikanordnung (210, 220, 230) und das erste Taktausgangssignal (PHI1) über eine dritte Verzögerungsstufe (290) der zweiten Logikanordnung (260, 270, 280) zugeführt wird.

7.  Taktsignalgenerator nach einem der vorhergehenden Ansprüche,
    **dadurch gekennzeichnet,**
    daß dieser derart ausgebildet ist, daß das erste (PHI1) und das zweite (PHI2) Taktausgangssignal im wesentlichen die gleiche Periodenlänge und einen im wesentlichen komplementären Amplitudenverlauf aufweisen.

8.  Taktsignalgenerator nach Anspruch 7,
    **dadurch gekennzeichnet,**
    daß die Nichtüberlappungszeiten der im wesentlichen komplementären Taktausgangssignale (PHI1, PHI2) durch geeignete Wahl der Verzögerung der Verzögerungsstufen einstellbar sind.

**Claims**

1.  Clock signal generator having a programmable duty ratio, having a clock input for a clock signal (CLK), having a first and a second clock output, having at least one first delay stage (140) with a selectable delay for delaying the clock signal, and having a controllable logic circuit (110, 120, 130), a first clock output signal (PHI1) and a second clock output signal (PHI2) being formed from the clock signal (CLK) and at least one selected, delayed signal,
    the logic circuit having an AND gate (110) and an OR gate (120) with two inputs each which in each case have the undelayed clock signal and the signal which has been delayed in the first delay stage (140) applied to them, and the output of the AND gate (110) or of the OR gate (120) being selectively supplied to a first (210, 220, 230) and to a second (260, 270, 280) logic arrangement.

2.  Clock signal generator according to Claim 1, characterized
    in that the delayed signal is selected by means of a multiplexer (145) which is connected to a multiplicity of delay paths (141-144) and can be controlled by a control signal (W1B) which can be input externally.

3.  Clock signal generator according to Claim 1, characterized
    in that a delayed signal is selected by making modifications to the wiring of a circuit design which has a multiplicity of delay paths (141-144).

4.  Clock signal generator according to Claim 1, characterized
    in that a delayed signal is selected by subsequently breaking wiring connections in a circuit which has a multiplicity of delay paths (141-144).

5.  Clock signal generator according to Claim 4, characterized
    in that the connections are broken by means of a laser beam.

6.  Clock signal generator according to Claim 1, characterized
    in that the first logic arrangement forms a first clock output signal (PHI1) and the second logic arrangement forms a second clock output signal (PHI2), the second clock output signal (PHI2) being supplied to the first logic arrangement (210, 220, 230) via a second delay stage (240), and the first clock output signal (PHI1) being supplied to the second logic arrangement (260, 270, 280) via a third delay stage (290).

7. Clock signal generator according to one of the preceding claims, characterized in that this clock signal generator is designed such that the first clock output signal (PHI1) and the second clock output signal (PHI2) have essentially the same period length and an essentially complementary amplitude profile.

8. Clock signal generator according to Claim 7, characterized in that the overlap-free times of the essentially complementary clock output signals (PHI1, PHI2) can be set by suitable choice of the delay in the delay stages.

## Revendications

1. Générateur de signal d'horloge ayant un rapport de cycle programmable et comportant une entrée d'horloge pour un signal d'horloge (CLK), une première sortie d'horloge et une deuxième sortie d'horloge, au moins un premier étage de retardement (140) avec retard sélectionnable pour retarder le signal d'horloge et un circuit logique commandable (110, 120, 130), un premier signal d'horloge de sortie (PHI1) et un deuxième signal d'horloge de sortie (PHI2) étant formés à partir du signal d'horloge (CLK) et d'au moins un signal sélectionné retardé,

   dans lequel le circuit logique comporte une porte ET (110) et une porte OU (120) ayant chacune deux entrées auxquelles sont appliqués respectivement le signal d'horloge non retardé et le signal retardé dans le premier étage de retardement (140) et dans lequel, au choix, le signal de sortie de la porte ET (110) ou le signal de sortie de la porte OU (120) est envoyé à un premier dispositif logique (210, 220, 230) et à un deuxième dispositif logique (260, 270, 280).

2. Générateur de signal d'horloge selon la revendication 1, caractérisé par le fait que le choix du signal retardé s'effectue au moyen d'un multiplexeur (145) qui est relié à plusieurs voies de retardement (141 à 144) et qui peut être commandé par un signal de commande (W1B) pouvant être entré de l'extérieur.

3. Générateur de signal d'horloge selon la revendication 1,

caractérisé par le fait que le choix d'un signal retardé s'effectue par une modification du câblage d'une conception de circuit qui comporte plusieurs voies de retardement (141 à 144).

4. Générateur de signal d'horloge selon la revendication 1, caractérisé par le fait que le choix d'un signal retardé s'effectue par une coupure ultérieure de câblages d'un circuit qui comporte plusieurs voies de retardement (141 à 144).

5. Générateur de signal d'horloge selon la revendication 4, caractérisé par le fait que la coupure de liaisons s'effectue au moyen d'un rayon laser.

6. Générateur de signal d'horloge selon la revendication 1, caractérisé par le fait que le premier dispositif logique forme un premier signal d'horloge de sortie (PHI1) et le deuxième dispositif logique forme un deuxième signal d'horloge de sortie (PHI2) et que le deuxième signal d'horloge de sortie (PHI2) est envoyé par l'intermédiaire d'un deuxième étage de retardement (240) au premier dispositif logique (210, 220, 230) et le premier signal d'horloge de sortie (PHI1) est envoyé par l'intermédiaire d'un troisième étage de retardement (290) au deuxième dispositif logique (260, 270, 280).

7. Générateur de signal d'horloge selon l'une des revendications précédentes, caractérisé par le fait qu'il est conçu de telle sorte que le premier signal d'horloge de sortie (PHI1) et le deuxième signal d'horloge de sortie (PHI2) présentent globalement les mêmes longueurs de période et une allure d'amplitude sensiblement complémentaire.

8. Générateur de signal d'horloge selon la revendication 7, caractérisé par le fait que les temps de non-chevauchement des signaux d'horloge de sortie (PHI1, PHI2) globalement complémentaires sont réglables par un choix approprié du retard des étages de retardement.

**FIG 1**

**FIG 2**

**FIG 3**